(19) Europäisches Patentamt
European Patent Office
Office européen des brevets

(11) **EP 4 109 740 B1**

(12) **EUROPEAN PATENT SPECIFICATION**

(45) Date of publication and mention
of the grant of the patent:
**26.11.2025 Bulletin 2025/48**

(21) Application number: **20920306.6**

(22) Date of filing: **20.02.2020**

(51) International Patent Classification (IPC):
*G01R 23/16* (2006.01)    *G01R 31/34* (2020.01)
*H02P 29/024* (2016.01)

(52) Cooperative Patent Classification (CPC):
**H02P 29/024; G01R 23/16; G01R 31/343**

(86) International application number:
**PCT/JP2020/006814**

(87) International publication number:
**WO 2021/166168 (26.08.2021 Gazette 2021/34)**

(54) **DEVICE FOR DIAGNOSING ELECTRIC MOTOR**

DIAGNOSEVORRICHTUNG FÜR EINEN ELEKTROMOTOR

DISPOSITIF DE DIAGNOSTIC DE MOTEUR ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**28.12.2022 Bulletin 2022/52**

(73) Proprietor: **MITSUBISHI ELECTRIC
CORPORATION
Chiyoda-ku
Tokyo 100-8310 (JP)**

(72) Inventors:
• **NAGAYAMA, Koki**
**Tokyo 100-8310 (JP)**
• **MIYAUCHI, Toshihiko**
**Tokyo 100-8310 (JP)**
• **TAKEUCHI, Norio**
**Tokyo 100-8310 (JP)**

(74) Representative: **Witte, Weller & Partner
Patentanwälte mbB
Postfach 10 54 62
70047 Stuttgart (DE)**

(56) References cited:
EP-A1- 2 725 370     WO-A1-2018/142569
JP-A- 2007 108 189    JP-A- 2010 206 964
JP-A- 2011 257 362    JP-A- 2015 227 889
JP-A- H03 178 585     US-A1- 2019 003 928

• YANG TING ET AL: "Feature Knowledge Based
Fault Detection of Induction Motors Through the
Analysis of Stator Current Data", IEEE
TRANSACTIONS ON INSTRUMENTATION AND
MEASUREMENT, IEEE, USA, vol. 65, no. 3, 1
March 2016 (2016-03-01), pages 549 - 558,
XP011598026, ISSN: 0018-9456, [retrieved on
20160208], DOI: 10.1109/TIM.2015.2498978
• JAKOV VICO ET AL: "Enhanced algorithm for
motor rotor broken bar detection", INDUSTRIAL
AND COMMERCIAL POWER SYSTEMS
TECHNICAL CONFERENCE (I&CPS), 2010 IEEE,
IEEE, PISCATAWAY, NJ, USA, 9 May 2010
(2010-05-09), pages 1 - 8, XP031693177, ISBN:
978-1-4244-5600-0

## Description

TECHNICAL FIELD

The present disclosure relates to an electric motor diagnosis device.

BACKGROUND ART

Electric motors are used for providing motive power for devices and machines forming a production line, such as pumps, compressors, air blowers, and industrial robots, and are indispensable in industries, and thus, always-sound continuous operation thereof is required.

Therefore, an electric motor diagnosis device that enables abnormality diagnosis by collecting and analyzing current information, voltage information, and zero-phase current information during operation of an electric motor has been proposed (e.g., Patent Document 1).

Non-Patent Document 1 relates to feature knowledge based fault detection of induction motors through the analysis of stator current data.

CITATION LIST

PATENT DOCUMENT

Patent Document 1: WO2019/102545

NON-PATENT DOCUMENT

Non-Patent Document 1: YANG TING ET AL: "Feature Knowledge Based Fault Detection of Induction Motors Through the Analysis of Stator Current Data"

SUMMARY OF THE INVENTION

PROBLEMS TO BE SOLVED BY THE INVENTION

Such a diagnosis method based on current information, voltage information, and zero-phase current information of an electric motor requires many sensors and the like for a diagnosis device. Therefore, there is a problem that the equipment is increased in size, and at the same time, cost of abnormality diagnosis for the electric motor is also increased.

The present disclosure has been made in order to solve the problem as described above. An object of the present disclosure is to obtain a diagnosis device that can diagnose an abnormality in an electric motor without obtaining a plurality of pieces of information of the electric motor.

SOLUTION TO THE PROBLEMS

According to the present disclosure, an electric motor diagnosis device as defined in independent claim 1 is provided.

EFFECT OF THE INVENTION

The electric motor diagnosis device of the present disclosure can diagnose an electric motor by using only current information of the electric motor, and enables abnormality diagnosis for the electric motor at low cost.

BRIEF DESCRIPTION OF THE DRAWINGS

[FIG. 1] FIG. 1 is a schematic configuration diagram of an electric motor diagnosis device in embodiment 1.
[FIG. 2] FIG. 2 is a block diagram of an arithmetic processing unit of the electric motor diagnosis device in embodiment 1.
[FIG. 3] FIG. 3 shows a normalized current-load rate curve in embodiment 1.
[FIG. 4A] FIG. 4A is a diagram describing correction of power spectra in embodiment 1.

[FIG. 4B] FIG. 4B is a diagram describing correction of power spectra in embodiment 1.

[FIG. 5] FIG. 5 is a diagram describing a diagnosis method in embodiment 1.

[FIG. 6] FIG. 6 is a flow chart describing operation of the diagnosis device in embodiment 1.

[FIG. 7] FIG. 7 is a flow chart describing operation by steps of FFT analysis in embodiment 1.

[FIG. 8] FIG. 8 is a hardware diagram of the electric motor diagnosis device in embodiment 1.

DESCRIPTION OF EMBODIMENTS

In the description of the embodiment and the drawings, parts denoted by the same reference characters are the same or corresponding parts.

Embodiment 1

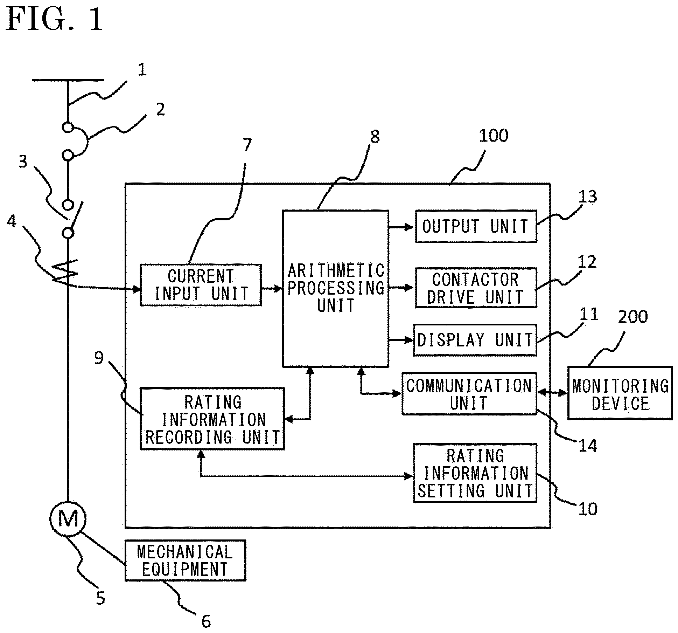

Hereinafter, embodiment 1 will be described with reference to FIG. 1 to FIG. 8.

<Configuration of electric motor diagnosis device>

FIG. 1 shows a schematic configuration diagram of an electric motor diagnosis device that is used in a control center of an enclosed switchboard or the like, and that diagnoses the presence or absence of an abnormality in an electric motor.

In FIG. 1, a main circuit 1 led from a power system is provided with a circuit breaker 2, an electromagnetic contactor 3, and a current detector 4 for detecting load current of the main circuit 1, and has connected thereto an electric motor 5 such as a three-phase induction electric motor. The electric motor 5 is connected to mechanical equipment 6 forming a production line and the like, and is driven.

In a diagnosis device 100 for the electric motor 5, a current input unit 7 to which current value data detected by the current detector 4 is inputted is disposed, and on the basis of the inputted current value data, arithmetic processing for diagnosing the electric motor 5 is executed in an arithmetic processing unit 8.

The diagnosis device 100 is provided with a rating information setting unit 10, and rating information such as the power supply frequency, the rated output, the rated current, the number of poles, and the rated rotation rate of the electric motor 5 is inputted in advance. These pieces of rating information inputted from the rating information setting unit 10 are stored in a rating information recording unit 9, and are sent to the arithmetic processing unit 8 as necessary, to be used in arithmetic processing.

Here, the rating information is basic information of the electric motor 5 described in a catalog of a manufacturing company of the electric motor 5, and the rating plate, an instruction manual, and the like of the electric motor 5. When a plurality of electric motors 5 are to be diagnosed, rating information corresponding to each electric motor 5 can be stored in the rating information recording unit 9, to be used. In the present embodiment 1, for simplification of description, a case where one electric motor 5 is to be diagnosed is described.

A display unit 11, a contactor drive unit 12, an output unit 13, and a communication unit 14 are connected to the arithmetic processing unit 8, and on the basis of a calculation result at the arithmetic processing unit 8, when an abnormality in the electric motor 5 has been detected, the display unit 11 displays the detected current value data, and also displays an abnormality state, an alarm, and the like.

Further, the contactor drive unit 12 outputs a control signal for opening/closing the electromagnetic contactor 3, and the output unit 13 outputs the abnormality state, the alarm, and the like, to a management department and the like of the production line. The communication unit 14 performs transmission, via a wired or wireless network or the like, to an external monitoring device 200 implemented by a personal computer or the like.

<Configuration of arithmetic processing unit>

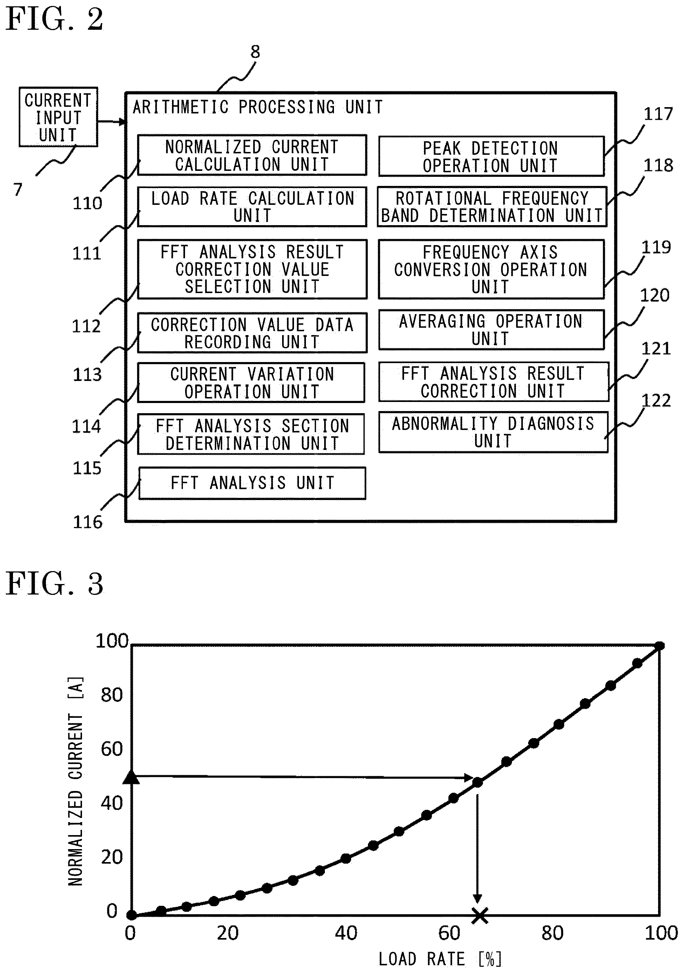

FIG. 2 is a block diagram of the arithmetic processing unit 8 of the diagnosis device 100, and shows a configuration of the arithmetic processing unit 8 which performs diagnosis for the electric motor 5 by using current value data inputted from the current input unit 7.

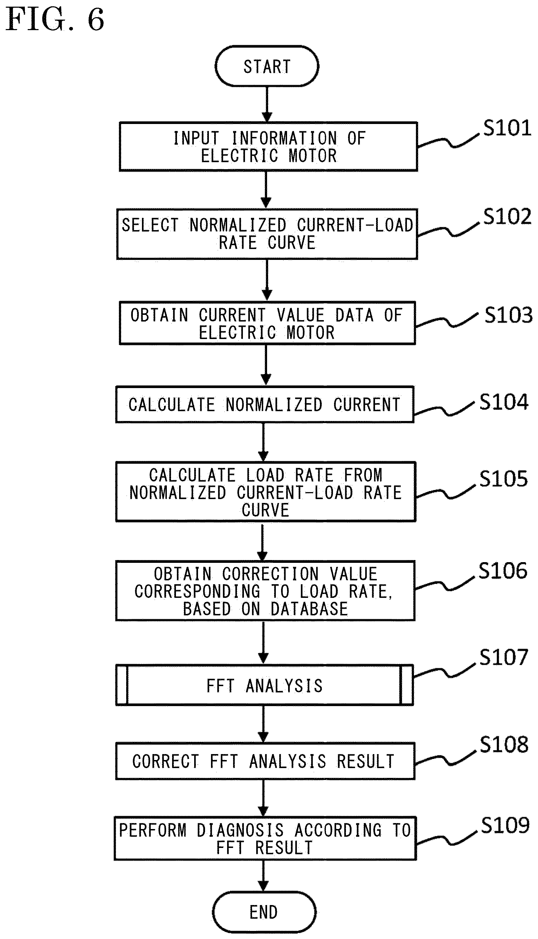

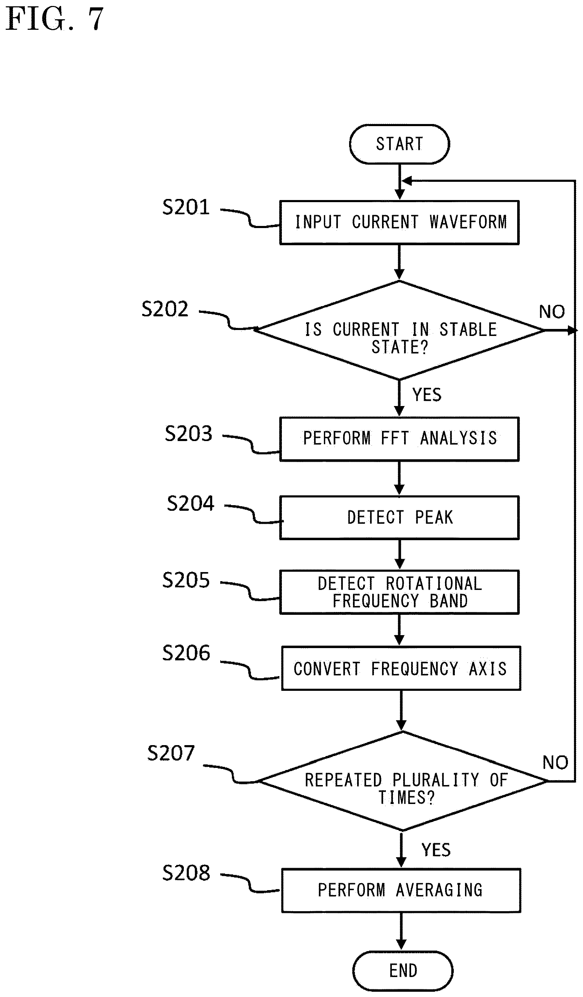

Here, roles, functions, and the like of the components forming the arithmetic processing unit 8 are described. The procedures of calculation, determination, and the like for diagnosing an abnormality in the electric motor 5 will be described later with reference to flow charts shown in FIG. 6 and FIG. 7.

A normalized current calculation unit 110 calculates a normalized current value by using Expression (1) from current value data (measured current) inputted from the current input unit 7, and current value data (no-load current) at the time of no load and current value data (rated current) at the time of the rated load recorded in the rating information recording unit 9.

$$\text{normalized current} =$$

$$((\text{measured current} - \text{no-load current})/(\text{rated current} - \text{no-load current}))\times100$$

$$...(1)$$

The measured current, which is current value data measured with respect to the electric motor 5, changes in a limited range so as to correspond to the state of the electric motor 5. Therefore, there are cases where it is difficult to find change in the state of the electric motor 5 on the basis of change in the measured current.

Therefore, the measured current is normalized on the basis of the difference from the no-load current, to be used in evaluation.

When normalized current is used, change in the measured current corresponding to the state of the electric motor 5 can be expressed in an emphasized manner.

In the present embodiment 1, a method of normalization represented by Expression (1) is used, but the present disclosure is not limited thereto. It is sufficient that change in current value data can be emphasized through normalization, and normalized current according to various normalization methods that facilitate understanding of the change can be used.

In a load rate calculation unit 111, a normalized current-load rate curve shown in FIG. 3 is used. The normalized current-load rate curve shown in FIG. 3 is created in advance from rating information such as rated current of the electric motor 5, and is stored in the rating information recording unit 9.

From the normalized current value (the black triangle in FIG. 3) calculated from the current value data in the normalized current calculation unit 110, extrapolation is performed on the normalized current-load rate curve, as indicated by arrows, to obtain a corresponding load rate ($\times$). The load rate used in the present embodiment 1 means the ratio of a load torque at the time of drive relative to the rated load torque of the electric motor 5.

FFT (Fast Fourier Transform) analysis described later is performed on current value data for diagnosis of the electric motor 5 for which diagnosis is performed, and an FFT analysis result is obtained. A correction value for adjusting the FFT analysis result is selected by an FFT analysis result correction value selection unit 112.

This correction value is obtained by performing FFT analysis on current value data of the electric motor 5 for a certain period before the time of diagnosis, and then accumulating and learning results of the analysis.

The correction value is recorded in a correction value data recording unit 113, as a database in the form of combination with a load rate at the time of obtainment of the current value data.

As an example, the load rate 0% to 100% is divided into 20 equal parts at intervals of 5%. Then, for 0% to not higher than 5%, a correction value A is given, and for higher than 5% and not higher than 10%, a correction value B is given. In this manner, a combination of a load rate and a correction value corresponding to the load rate is recorded as a database. With use of this database, an appropriate correction value that corresponds to the load rate calculated by the load rate calculation unit 111 described above is selected.

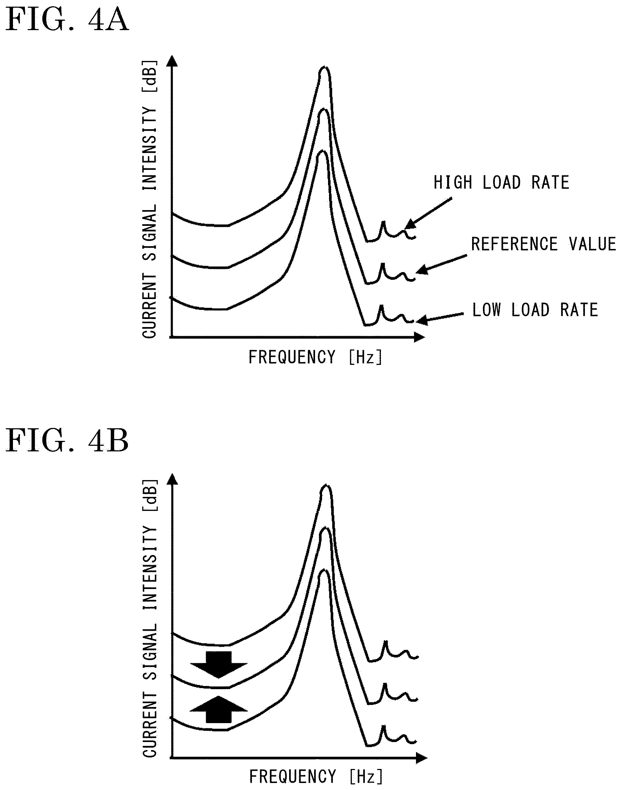

With reference to FIG. 4A and FIG. 4B, the correction value used in the present embodiment 1 is further described.

Before performing diagnosis for the electric motor 5 of the present embodiment 1, FFT analysis is repeatedly performed for a certain period on current value data of the electric motor 5 during normal operation, whereby a plurality of pieces of power spectrum data being analysis results are accumulated. These pieces of power spectrum data respectively have different load rates in accordance with the use conditions of the electric motor 5. Therefore, as shown in FIG. 4A, when the power spectrum data that most frequently appears is used as a reference value, the power spectrum data changes between a case where the electric motor 5 is at a high load rate and a case where the electric motor 5 is at a low load rate.

Therefore, in order to cause the pieces of the power spectrum data at the time of a high load rate and at the time of a low load rate to match the reference value, thereby eliminating influence due to the difference in the load rate with respect to the power spectrum data of the electric motor 5, the current signal intensity is increased/decreased as schematically shown by arrows in FIG. 4B. The adjustment value for this increase/decrease is the correction value.

This correction value and the load rate of the electric motor 5 at the time of occurrence of the corresponding power spectrum data are combined together to be recorded as a database. On the basis of the load rate obtained through the normalized current-load rate curve from the current value data at the time of diagnosis, an appropriate correction value can be selected, and thus, accuracy of analysis of the power spectrum data can be improved.

A current variation operation unit 114 determines the presence or absence of variation in the current value data measured with respect to the electric motor 5, and detects whether or not a stable state is established.

The current variation operation unit 114 executes statistical variation analysis on the current value data. For example, the current variation operation unit 114 analyzes variation through calculation of the standard deviation of the current value data, a Mahalanobis distance, and the like.

An FFT analysis section determination unit 115 determines an FFT analysis section by extracting a section in which a stable state is established, from the measured current value data. Specifically, a section in which the statistical variation obtained by the current variation operation unit 114 is not greater than a threshold determined in advance is a section in which a stable state is established.

In general, when the load torque of the electric motor 5 varies, variation occurs in the current value data. If FFT analysis is performed by using such current value data, the current signal intensities in frequency sections on both sides of the power supply frequency increase, and thus peak detection becomes difficult. Therefore, the FFT analysis section determination unit 115 is provided to extract a section in which a stable state is established, and the extracted section is used in FFT analysis, whereby peak detection can be facilitated.

An FFT analysis unit 116 performs FFT analysis on the section obtained by the FFT analysis section determination unit 115, and a peak detection operation unit 117 specifies a peak position included in the obtained power spectrum data.

The peak detection operation unit 117 detects a peak due to a power supply frequency, a peak due to a rotational frequency of the electric motor 5, and the like from the power spectrum data. The peak detection is performed by extracting a part where a sharp slope is inverted, through first-order, second-order, and third-order differential calculation. By performing the differential calculation up to third order, it becomes possible to detect a peak that has a smaller current signal intensity.

From the peaks detected by the peak detection operation unit 117, a rotational frequency band determination unit 118 specifies a peak position due to the rotational frequency.

The rotational frequency is obtained from the rated rotation rate stored in the rating information recording unit 9. Then, peaks that are separated from the power supply frequency to both of the high frequency side and the low frequency side by an amount corresponding to the rotational frequency, and that have similar current signal intensities, are extracted.

With respect to the electric motor 5, shift occurs in the rotation rate in accordance with the condition of the load torque. Therefore, there are cases where shift occurs in the peak due to the rotational frequency. The rotational frequency band determination unit 118 specifies a rotational frequency band in which the peak position is included in a frequency band in consideration of this shift.

A frequency axis conversion operation unit 119 calculates a conversion axis for aligning rotational frequency bands of power spectrum data obtained through measurements repeated a plurality of times. An averaging operation unit 120 performs an averaging process by performing integration, a plurality of times, of power spectrum data to which these conversion axes are applied.

The frequency axis conversion operation unit 119 is necessary for causing correct operation of the averaging operation unit 120 to be performed.

As described above, the rotational frequency band appears while being shifted in accordance with the condition of the load torque of the electric motor 5. Therefore, in order to cause a plurality of FFT analysis results to be correctly aligned with each other to perform averaging, the frequency axes of the power spectrum data need to be aligned with each other. Specifically, in a case where the rotational frequency band changes such that a conversion ratio $\alpha$ is multiplied in accordance with the condition of the load torque of the electric motor 5, if conversion is performed by multiplying the frequency axis by the conversion ratio $\alpha$, the averaging process can be correctly performed.

An FFT analysis result correction unit 121 corrects power spectrum data for diagnosis of the electric motor 5, by using a correction value selected by the FFT analysis result correction value selection unit 112 so as to correspond to the load rate of the electric motor 5. Correction value information of the FFT analysis result is accumulated in the rating information recording unit 9 upon start of the electric motor 5, and is also retained after stop of the electric motor 5.

In the present embodiment 1, an example in which a correction value is assigned to each of 20 equal parts obtained by equally dividing the load rate has been shown. However, the present disclosure is not limited thereto. The number of divisions, etc., can be changed in adjustment and setting of the diagnosis device 100 for the electric motor 5.

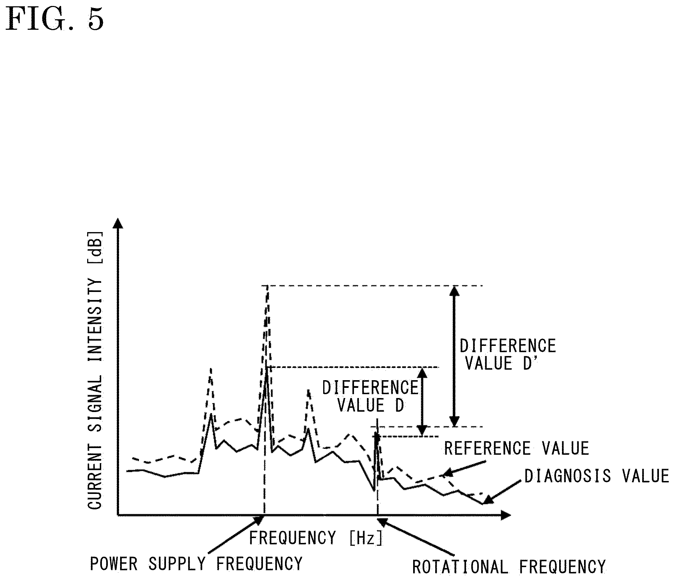

An abnormality diagnosis unit 122 performs diagnosis for the electric motor 5 with respect to the corrected power spectrum data. Abnormality detection by the abnormality diagnosis unit 122 is described with reference to FIG. 5. In FIG. 5, the solid line represents power spectrum data (diagnosis value) at the time of diagnosis, and a difference value D between the current signal intensities of power spectrum data at the power supply frequency and power spectrum data at the rotational frequency is obtained.

The broken line represents the reference value in FIG. 4B used in the process of obtaining a correction value corresponding to the load rate by performing FFT analysis on the current value data of the electric motor 5 for a certain period before the time of diagnosis. With respect to the reference value as well, a difference value between the current signal intensities of power spectrum data at the power supply frequency and power spectrum data at the rotational frequency is obtained and is defined as a difference value D'.

The difference value D' is a difference value when the electric motor 5 is operating normally before the time of diagnosis. Therefore, if the electric motor 5 is operating normally at the time of diagnosis, it can be considered that the difference value D at the time of diagnosis is substantially equal to the difference value D'. Conversely, when the difference value D at time of diagnosis and the difference value D' are different from each other by not less than a certain value determined in advance, it is determined that an abnormality has occurred in the electric motor 5 at the time of diagnosis.

In FIG. 5, the difference value D' is depicted to be larger than the difference value D for convenience of description, but FIG. 5 does not reflect the actual data.

<Flow of diagnosis for electric motor>

Procedures of performing calculation, determination, and the like for diagnosing the electric motor 5 are described with reference to flow charts in FIG. 6 and FIG. 7.

The flow of diagnosis for the electric motor 5 is composed of step S101 to step S109 as shown in FIG. 6, and, among these, FFT analysis shown in step S107 is performed by execution of step S201 to step S208 shown in FIG. 7.

The diagnosis device 100 for the electric motor 5 is started at a predetermined time interval, and executes the following processes shown in FIG. 6 and FIG. 7.

In step S101, information of the electric motor 5 is inputted from the rating information setting unit 10, and is recorded into the rating information recording unit 9. The information of the electric motor 5 is rating information such as the number of poles, rated output, power supply frequency, and voltage rating of the electric motor 5, and current value information at the time of no load and at the time of rated operation, and can be obtained from a catalog, a test report, a rating plate, or the like of the electric motor 5.

The rating information recording unit 9 has recorded therein a normalized current-load rate curve which represents the relationship between load rate and normalized current of the electric motor 5 shown in FIG. 3. In step S102, the normalized current-load rate curve is obtained from the rating information recording unit 9.

In step S103, current value data of the diagnosis target electric motor 5 is obtained by the current detector 4, and is inputted to the current input unit 7. In step S104, in the normalized current calculation unit 110, normalized current is calculated by using Expression (1), from the diagnosis target current value data inputted in the current input unit 7 and the electric motor information of the electric motor 5 recorded in the rating information recording unit 9.

In step S105, the normalized current of the electric motor 5 calculated in step S104 is applied, as indicated by the arrows in FIG. 3, to the normalized current-load rate curve obtained from the rating information recording unit 9 in step S102, and then, in the load rate calculation unit 111, a value (×) of the load rate corresponding to the value (black triangle) of the normalized current of the electric motor 5 is obtained.

In step S106, a database obtained in advance is used. The database is recorded in the correction value data recording unit 113, and has recorded therein a load rate and a correction value of power spectrum data obtained as a result of FFT analysis of current value data in combination.

In the FFT analysis result correction value selection unit 112, a correction value of the FFT analysis result corresponding to the load rate of the electric motor 5 obtained in step S105 is obtained on the basis of the database.

In step S107, in the FFT analysis unit 116, FFT analysis of the diagnosis target current value data obtained by the current detector 4 is performed. Further, in the FFT analysis in step S107, step S201 to step S208 to be described later and shown in FIG. 7 are performed.

In step S108, with respect to the result of the FFT analysis performed in step S107, correction is performed by the FFT analysis result correction unit 121 by using the correction value obtained so as to correspond to the load rate from the database in step S106.

In step S109, as described with reference to FIG. 5, with respect to the result, of the FFT analysis at the time of diagnosis obtained in step S108, in which influence due to the difference in the load rate has been corrected by using a correction value selected from the database, a difference value D between the current signal intensities of power spectrum data at the power supply frequency and power spectrum data at the rotational frequency is calculated.

Similarly, also with respect to the reference value of power spectrum data measured before the time of diagnosis and in a state where the electric motor 5 is normally performing normal operation, a difference value between the current signal intensities of power spectrum data at the power supply frequency and power spectrum data at the rotational frequency is calculated and is defined as a difference value D'.

When the difference value D' obtained in advance during normal operation and the difference value D at the time of diagnosis has a difference of not less than a certain magnitude determined in advance, it can be determined, in the abnormality diagnosis unit 122, that an abnormality has occurred in the electric motor 5.

Details of the step of FFT analysis in step S107 shown in FIG. 6 are described with reference to the flow chart in FIG. 7.

In step S201, the diagnosis target current value data of the electric motor 5 detected by the current detector 4 is inputted in the current input unit 7.

In step S202, variation of the inputted current value data is calculated by the current variation operation unit 114, and whether or not the current value data is stable is determined by the FFT analysis section determination unit 115. When the variation in the current value data is not less than a value set in advance, it is determined that the state is an unstable state (NO), and the process is returned to step S201. When it is determined that the state is a stable state (YES), the process is advanced to step S203.

As for the threshold used as a reference for determination of whether or not the state is a stable state, pieces of current value data of the electric motors 5 of a plurality of types may be obtained in advance, for example, and the threshold may be selected to be in a range smaller than the standard deviation of the pieces of current value data. Alternatively, current value data of the evaluation target electric motor 5 may be collected for a certain period, and a threshold may be set by using the standard deviation of the current value data in this period as a reference.

In step S203, the FFT analysis unit 116 performs FFT analysis by using current value data of a section in which the inputted current value data is in a stable state. As an example, FFT analysis is performed with respect to frequencies from 0 Hz to a frequency of 120 Hz, which is two times the power supply frequency of 60 Hz, and an analysis result is sent to the peak detection operation unit 117.

In step S204, the peak detection operation unit 117 extracts all peaks in the analysis result. In step S205, the rotational frequency band determination unit 118 extracts a peak in the rotational frequency band from the detected peaks, and specifies the rotational frequency band.

In step S206, the frequency axis conversion operation unit 119 converts the frequency axes of all the peaks such that the specified rotational frequency band becomes the rotational frequency band at the time of no load while influence of frequency shift due to the load torque is removed.

In step S207, operations of step S201 to step S206 are repeated a plurality of times, thereby performing FFT analysis, and pieces of power spectrum data for which the frequency axes have been converted are collected.

In step S208, the averaging operation unit 120 performs an averaging process on the plurality of pieces of power spectrum data for which FFT analysis has been performed, to remove influence of noise of the power spectrum data.

Finally, the process is returned to step S108 of the flow chart shown in FIG. 6, and correction of the analysis result and diagnosis are performed.

As described above, a database that determines a relationship between the load rate and the correction value necessary for power spectrum data is created before the time of diagnosis, and power spectrum data being the result of FFT analysis regarding the electric motor 5 is corrected, whereby diagnosis for the electric motor 5 can be performed with high accuracy.

In abnormality diagnosis for an electric motor in a conventional diagnosis device, a plurality of types of information such as current information, voltage information, and zero-phase current information are necessary. However, in the electric motor diagnosis device shown in the present embodiment 1, a similar level of high diagnosis accuracy can be obtained by using current information only. Therefore, introduction of the electric motor diagnosis device is easy when compared with a conventional device, and introduction of a diagnosis device at low cost can also be realized.

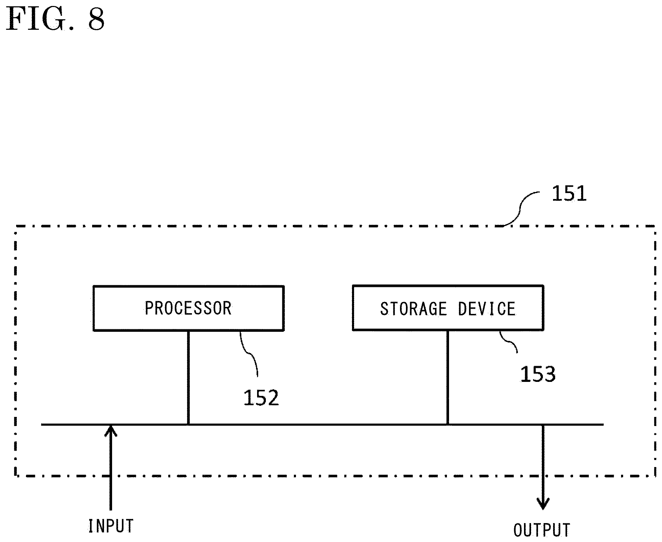

FIG. 8 shows an example of hardware 151 that performs calculation and the like in the arithmetic processing unit 8 of the diagnosis device 100 in the embodiment of the present disclosure.

As shown in FIG. 8, the hardware 151 is implemented by a processor 152 and a storage device 153. The storage device includes, although not shown, a volatile storage device such as a random access memory, and a non-volatile auxiliary storage device such as a flash memory. Instead of a flash memory, an auxiliary storage device of a hard disk may be provided. The processor 152 executes a program inputted from the storage device 153. In this case, the program is inputted from the auxiliary storage device to the processor 152 via the volatile storage device. The processor 152 may output data such as a calculation result to the volatile storage device of the storage device 153, or may store data into the auxiliary storage device via the volatile storage device.

Although the present disclosure is described above in terms of an exemplary embodiment, it should be understood that the various features, aspects, and functionality described in the embodiment are not limited in their applicability to the particular embodiment with which they are described, but instead can be applied alone or in various combinations to the embodiment of the disclosure.

DESCRIPTION OF THE REFERENCE CHARACTERS

1   main circuit
2   circuit breaker
3   electromagnetic contactor
4   current detector
5   electric motor
6   mechanical equipment

7      current input unit
8      arithmetic processing unit
9      rating information recording unit
10     rating information setting unit
11     display unit
12     contactor drive unit
13     output unit
14     communication unit
100    diagnosis device
110    normalized current calculation unit
111    load rate calculation unit
112    FFT analysis result correction value selection unit
113    correction value data recording unit
114    current variation operation unit
115    FFT analysis section determination unit
116    FFT analysis unit
117    peak detection operation unit
118    rotational frequency band determination unit
119    frequency axis conversion operation unit
120    averaging operation unit
121    FFT analysis result correction unit
122    abnormality diagnosis unit
151    hardware
152    processor
153    storage device
200    monitoring device

**Claims**

1. An electric motor diagnosis device comprising:

a current input unit (7) for inputting current value data of an electric motor (5);
an FFT analysis unit (116) for performing FFT analysis on the current value data, to obtain power spectrum data;
a normalized current calculation unit (110) for calculating normalized current from the current value data;
a load rate calculation unit (111) for obtaining a load rate corresponding to the normalized current calculated by the normalized current calculation unit (110), by using a normalized current-load rate curve obtained from set information of the electric motor (5);
a correction value data recording unit (113) in which a correction value for adjusting influence due to a difference in the load rate of the power spectrum data at a time of diagnosis relative to a reference value of the power spectrum data is recorded in a database so as to correspond to the load rate;
an FFT analysis result correction value selection unit (112) for selecting the correction value on the basis of the database and the load rate, at the time of diagnosis, obtained by the load rate calculation unit (111);
an FFT analysis result correction unit (121) for correcting the power spectrum data at the time of diagnosis by the correction value; and
an abnormality diagnosis unit (122) for, with respect to each of the reference value and the corrected power spectrum data at the time of diagnosis, calculating a difference value between current signal intensities at a power supply frequency and at a rotational frequency, and diagnosing the electric motor through comparison of the difference values with each other,
wherein the normalized current denotes a ratio of a difference between measured current and no-load current relative to a difference between rated current and the no-load current.

2. The electric motor diagnosis device according to claim 1, wherein

the reference value is the power spectrum data that most frequently appears among a plurality of pieces of the power spectrum data that have been obtained by performing FFT analysis on the current value data during normal operation of the electric motor (5), and that have been accumulated through repetition for a certain period before the time of diagnosis, and
the correction value is an adjustment value for causing, among the plurality of pieces of the power spectrum data, the power spectrum data that is separated from the reference value to match the reference value by increasing or decreasing a current signal intensity of the power spectrum data that is separated from the reference value.

3. The electric motor diagnosis device according to claim 1 or 2, comprising:

for the FFT analysis of the current value data performed in the FFT analysis unit (116),
a current variation operation unit (114) for evaluating statistical variation of the current value data; and
an FFT analysis section determination unit (115) for selecting, as an FFT analysis section, a section in which the statistical variation is not higher than a certain value.

4. The electric motor diagnosis device according to any one of claims 1 to 3, comprising:

a frequency axis conversion operation unit (119) for converting a frequency axis of each of a plurality of pieces of the power spectrum data, thereby causing rotational frequency bands for peaks, due to the rotational frequency, of the plurality of pieces of the power spectrum data, to match each other; and
an averaging operation unit (120) for averaging the plurality of pieces of the power spectrum data for which the frequency axes have each been converted.

5. The electric motor diagnosis device according to any one of claims 1 to 4, wherein
the load rate is a ratio of a load torque during operation relative to a rated load torque.

**Patentansprüche**

1. Elektromotordiagnosevorrichtung, umfassend:

eine Stromeingabeeinheit (7) zum Eingeben von Stromwertdaten eines Elektromotors (5);
eine EFT-Analyseeinheit (116) zum Durchführen einer FFT-Analyse der Stromwertdaten, um Leistungsspektrumdaten zu erhalten;
eine Einheit (110) für eine Berechnung eines normalisierten Stroms zum Berechnen des normalisierten Stroms aus den Stromwertdaten;
eine Lastratenberechnungseinheit (111) zum Erhalten einer Lastrate, die dem durch die Einheit (110) für die Berechnung eines normalisierten Stroms normalisierten Strom entspricht, durch Verwenden einer aus eingestellten Informationen des Elektromotors (5) erhaltenen Lastratenkurve für normalisierten Strom;
eine Korrekturwertdatenaufzeichnungseinheit (113), in der ein Korrekturwert zum Anpassen eines Einflusses aufgrund einer Differenz der Lastrate der Leistungsspektrumdaten zu einem Zeitpunkt der Diagnose relativ zu einem Referenzwert der Leistungsspektrumdaten in einer Datenbank aufgezeichnet wird, um der Lastrate zu entsprechen;
eine Einheit (112) für eine Auswahl eines Korrekturwerts für das FFT-Analyseergebnis zum Auswählen des Korrekturwerts auf der Basis der Datenbank und der Lastrate zu dem Zeitpunkt der Diagnose, die durch die Lastratenberechnungseinheit (111) erhalten wurde;
eine Korrektureinheit (121) für das FFT-Analyseergebnis zum Korrigieren der Leistungsspektrumdaten zu dem Zeitpunkt der Diagnose um den Korrekturwert; und
eine Abnormalitätsdiagnoseeinheit (122) zum Berechnen eines Differenzwerts zwischen Stromsignalintensitäten bei einer Leistungsversorgungsfrequenz und einer Rotationsfrequenz in Bezug auf jeweils den Referenzwert und die korrigierten Leistungsspektrumdaten zu dem Zeitpunkt der Diagnose und zum Diagnostizieren des Elektromotors durch Vergleichen der Differenzwerte miteinander,
wobei der normalisierte Strom ein Verhältnis einer Differenz zwischen gemessenem Strom und Leerlaufstrom relativ zu einer Differenz zwischen Nennstrom und Leerlaufstrom bezeichnet.

2. Elektromotordiagnosevorrichtung nach Anspruch 1, wobei

der Referenzwert die Leistungsspektrumdaten ist, die am häufigsten unter einer Vielzahl von Leistungsspektrumdaten auftreten, die durch Durchführen einer FFT-Analyse der Stromwertdaten während eines Normalbetriebs des Elektromotors (5) erhalten wurden und die durch Wiederholung für einen bestimmten Zeitraum vor dem Zeitpunkt der Diagnose akkumuliert wurden, und
der Korrekturwert ein Anpassungswert ist zum Bewirken, dass aus der Vielzahl von Leistungsspektrumdaten die Leistungsspektrumdaten, die von dem Referenzwert abweichen, mit dem Referenzwert übereinstimmen, durch

**EP 4 109 740 B1**

Erhöhen oder Verringern einer aktuellen Signalintensität der Leistungsspektrumdaten, die von dem Referenzwert abweichen.

3. Elektromotordiagnosevorrichtung nach Anspruch 1 oder 2, umfassend:

für die in der FFT-Analyseeinheit (116) durchgeführte FFT-Analyse der Stromwertdaten,
eine Stromvariationsbetriebseinheit (114) zum Auswerten einer statistischen Variation der Stromwertdaten; und
eine FFT-Analyseabschnittbestimmungseinheit (115) zum Auswählen eines Abschnitts, in dem die statistische Variation nicht höher als ein bestimmter Wert ist, als einen FFT-Analyseabschnitt.

4. Elektromotordiagnosevorrichtung nach einem der Ansprüche 1 bis 3, umfassend:

eine Frequenzachsen-Konvertierungsbetriebseinheit (119) zum Konvertieren einer Frequenzachse jedes einer Vielzahl von Leistungsspektrumdaten, wodurch bewirkt wird, dass Rotationsfrequenzbänder für Spitzen aufgrund der Rotationsfrequenz der Vielzahl von Leistungsspektrumdaten aneinander entsprechen; und
eine Mittelwertbildungseinheit (120) zum Bilden des Durchschnitts der Vielzahl von Leistungsspektrumdaten, deren Frequenzachsen jeweils konvertiert wurden.

5. Elektromotordiagnosevorrichtung nach einem der Ansprüche 1 bis 4, wobei
die Lastrate ein Verhältnis eines Lastdrehmoments während des Betriebs relativ zu einem Nennlastdrehmoment ist.


**Revendications**

1. Dispositif de diagnostic de moteur électrique comprenant :

une unité d'entrée de courant (7) pour entrer des données de valeur de courant d'un moteur électrique (5) ;
une unité d'analyse FFT (116) pour réaliser une analyse FFT sur les données de valeur de courant, afin d'obtenir des données de spectre de puissance ;
une unité de calcul de courant normalisé (110) pour calculer un courant normalisé à partir des données de valeur de courant ;
une unité de calcul de taux de charge (111) pour obtenir un taux de charge correspondant au courant normalisé calculé par l'unité de calcul de courant normalisé (110), en utilisant une courbe courant normalisé-taux de charge obtenue à partir des informations de réglage du moteur électrique (5) ;
une unité d'enregistrement de données de valeur de correction (113) dans laquelle une valeur de correction pour ajuster une influence due à une différence dans le taux de charge des données de spectre de puissance à un moment du diagnostic par rapport à une valeur de référence des données de spectre de puissance est enregistrée dans une base de données de manière à correspondre au taux de charge ;
une unité de sélection de valeur de correction de résultat d'analyse FFT (112) pour sélectionner la valeur de correction sur la base de la base de données et du taux de charge, au moment du diagnostic, obtenu par l'unité de calcul de taux de charge (111) ;
une unité de correction de résultat d'analyse FFT (121) pour corriger les données de spectre de puissance au moment du diagnostic par la valeur de correction ; et
une unité de diagnostic d'anomalies (122) pour, par rapport à chacun de la valeur de référence et des données de spectre de puissance corrigées au moment du diagnostic, calculer une valeur de différence entre des intensités de signaux de courant à une fréquence d'alimentation et à une fréquence de rotation, et diagnostiquer le moteur électrique en comparant les valeurs de différence l'une par rapport à l'autre,
dans lequel le courant normalisé représente un rapport entre une différence entre un courant mesuré et un courant à vide et une différence entre un courant nominal et un courant à vide.

2. Dispositif de diagnostic de moteur électrique selon la revendication 1, dans lequel

la valeur de référence correspond aux données de spectre de puissance qui apparaissent le plus fréquemment parmi une pluralité d'éléments de données de spectre de puissance qui ont été obtenues en réalisant une analyse FFT sur les données de valeur de courant pendant un fonctionnement normal du moteur électrique (5), et qui ont été accumulées par répétition pendant une certaine période avant le moment du diagnostic, et
la valeur de correction est une valeur d'ajustement permettant de faire correspondre, parmi la pluralité d'éléments de données de spectre de puissance, les données de spectre de puissance qui sont distinctes de la valeur de référence en augmentant ou en diminuant une intensité de signal de courant des données de spectre de puissance distinctes de la valeur de référence.

3. Dispositif de diagnostic de moteur électrique selon la revendication 1 ou 2, comprenant :

pour l'analyse FFT des données de valeur de courant réalisée dans l'unité d'analyse FFT (116), une unité d'opération de variation de courant (114) pour évaluer une variation statistique des données de valeur de courant ; et une unité de détermination de section d'analyse FFT (115) pour sélectionner, en tant que section d'analyse FFT, une section dans laquelle la variation statistique n'est pas supérieure à une certaine valeur.

4. Dispositif de diagnostic de moteur électrique selon l'une quelconque des revendications 1 à 3, comprenant :

une unité d'opération de conversion d'axe de fréquence (119) pour convertir un axe de fréquence de chacun d'une pluralité d'éléments de données de spectre de puissance, ce qui permet de faire correspondre des bandes de fréquence de rotation pour des pics, en raison de la fréquence de rotation, de la pluralité d'éléments de données de spectre de puissance ; et une unité d'opération de calcul de moyenne (120) pour calculer la moyenne de la pluralité d'éléments de données de spectre de puissance pour lesquelles les axes de fréquence ont été convertis.

5. Dispositif de diagnostic de moteur électrique selon l'une quelconque des revendications 1 à 4, dans lequel le taux de charge est un rapport entre un couple de charge en fonctionnement et un couple de charge nominale.

FIG. 1

# FIG. 2

CURRENT INPUT UNIT

ARITHMETIC PROCESSING UNIT

| NORMALIZED CURRENT CALCULATION UNIT | PEAK DETECTION OPERATION UNIT |
|---|---|
| LOAD RATE CALCULATION UNIT | ROTATIONAL FREQUENCY BAND DETERMINATION UNIT |
| FFT ANALYSIS RESULT CORRECTION VALUE SELECTION UNIT | FREQUENCY AXIS CONVERSION OPERATION UNIT |
| CORRECTION VALUE DATA RECORDING UNIT | AVERAGING OPERATION UNIT |
| CURRENT VARIATION OPERATION UNIT | FFT ANALYSIS RESULT CORRECTION UNIT |
| FFT ANALYSIS SECTION DETERMINATION UNIT | ABNORMALITY DIAGNOSIS UNIT |
| FFT ANALYSIS UNIT | |

8
7
110
111
112
113
114
115
116
117
118
119
120
121
122

# FIG. 3

FIG. 4A

FIG. 4B

# FIG. 5

## FIG. 6

```
        START
          │
          ▼
┌─────────────────────┐
│  INPUT INFORMATION OF │ ╌╌ S101
│    ELECTRIC MOTOR     │
└─────────────────────┘
          │
          ▼
┌─────────────────────┐
│ SELECT NORMALIZED CURRENT-LOAD │ ╌╌ S102
│       RATE CURVE      │
└─────────────────────┘
          │
          ▼
┌─────────────────────┐
│ OBTAIN CURRENT VALUE DATA OF │ ╌╌ S103
│     ELECTRIC MOTOR    │
└─────────────────────┘
          │
          ▼
┌─────────────────────┐
│ CALCULATE NORMALIZED CURRENT │ ╌╌ S104
└─────────────────────┘
          │
          ▼
┌─────────────────────┐
│  CALCULATE LOAD RATE FROM │ ╌╌ S105
│ NORMALIZED CURRENT-LOAD RATE │
│        CURVE          │
└─────────────────────┘
          │
          ▼
┌─────────────────────┐
│   OBTAIN CORRECTION VALUE │ ╌╌ S106
│ CORRESPONDING TO LOAD RATE, │
│    BASED ON DATABASE  │
└─────────────────────┘
          │
          ▼
┌─────────────────────┐
│     FFT ANALYSIS      │ ╌╌ S107
└─────────────────────┘
          │
          ▼
┌─────────────────────┐
│ CORRECT FFT ANALYSIS RESULT │ ╌╌ S108
└─────────────────────┘
          │
          ▼
┌─────────────────────┐
│ PERFORM DIAGNOSIS ACCORDING TO │ ╌╌ S109
│       FFT RESULT      │
└─────────────────────┘
          │
          ▼
         END
```

# FIG. 7

```
                    ┌──────────┐
                    │  START   │
                    └──────────┘
                          │
                          ▼
S201 ──────┐    ┌──────────────────────────┐
           │    │  INPUT CURRENT WAVEFORM  │
           └────└──────────────────────────┘
                          │
                          ▼
S202 ──────┐        ◇─────────────────◇   NO
           │       ╱  IS CURRENT IN    ╲ ─────▶
           └──────◇   STABLE STATE?     ◇
                   ╲                    ╱
                    ◇─────────────────◇
                          │ YES
                          ▼
S203 ──────┐    ┌──────────────────────────┐
           │    │   PERFORM FFT ANALYSIS   │
           └────└──────────────────────────┘
                          │
                          ▼
S204 ──────┐    ┌──────────────────────────┐
           │    │       DETECT PEAK        │
           └────└──────────────────────────┘
                          │
                          ▼
S205 ──────┐    ┌──────────────────────────┐
           │    │   DETECT ROTATIONAL      │
           └────│   FREQUENCY BAND         │
                └──────────────────────────┘
                          │
                          ▼
S206 ──────┐    ┌──────────────────────────┐
           │    │  CONVERT FREQUENCY AXIS  │
           └────└──────────────────────────┘
                          │
                          ▼
S207 ──────┐        ◇─────────────────◇   NO
           │       ╱  REPEATED PLURALITY╲ ─────▶
           └──────◇    OF TIMES?         ◇
                   ╲                    ╱
                    ◇─────────────────◇
                          │ YES
                          ▼
S208 ──────┐    ┌──────────────────────────┐
           │    │    PERFORM AVERAGING     │
           └────└──────────────────────────┘
                          │
                          ▼
                    ┌──────────┐
                    │   END    │
                    └──────────┘
```

# FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019102545 A

**Non-patent literature cited in the description**

- **YANG TING et al.** *Feature Knowledge Based Fault Detection of Induction Motors Through the Analysis of Stator Current Data*